(19) Europäisches Patentamt
European Patent Office
Office européen des brevets

(11) **EP 2 989 675 B1**

(12) **EUROPEAN PATENT SPECIFICATION**

(45) Date of publication and mention of the grant of the patent:
**12.04.2017 Bulletin 2017/15**

(21) Application number: **14707912.3**

(22) Date of filing: **19.02.2014**

(51) Int Cl.:
**H01M 10/0525** (2010.01)  **H01M 10/48** (2006.01)

(86) International application number:
**PCT/US2014/017078**

(87) International publication number:
**WO 2014/130519 (28.08.2014 Gazette 2014/35)**

(54) **METHOD AND SYSTEM FOR ESTIMATING A CAPACITY OF INDIVIDUAL ELECTRODES AND THE TOTAL CAPACITY OF A LITHIUM-ION BATTERY SYSTEM**

VERFAHREN UND VORRICHTUNG ZUR MESSUNG DER KAPAZITÄT EINZELNER ELEKTRODEN SOWIE DER GESAMTKAPAZITÄT EINES LITHIUM-IONEN-BATTERIESYSTEMS

PROCÉDÉ ET SYSTÈME POUR ESTIMER UNE CAPACITÉ DES ÉLECTRODES INDIVIDUELLES ET LA CAPACITÉ TOTALE D'UN SYSTÈME DE BATTERIE AU LITHIUM-ION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **21.02.2013 US 201361767502 P**

(43) Date of publication of application:
**02.03.2016 Bulletin 2016/09**

(73) Proprietor: **Robert Bosch GmbH**
**70442 Stuttgart (DE)**

(72) Inventors:
• **CHATURVEDI, Nalin**
**Sunnyvale, CA 94086 (US)**
• **KLEIN, Reinhardt**
**Mountain View, CA 94040 (US)**
• **CHRISTENSEN, John**
**Mountain View, CA 94043 (US)**
• **AHMED, Jasim**
**Mountain View, CA 94041 (US)**
• **KOJIC, Aleksander**
**Sunnyvale, CA 94086 (US)**

(74) Representative: **Bee, Joachim**
**Robert Bosch GmbH**
**Zentralabteilung Patente**
**Postfach 30 02 20**
**70442 Stuttgart (DE)**

(56) References cited:
**EP-A1- 1 562 048**      **WO-A1-2013/173610**
**US-A1- 2012 105 068**

**Description**

This application claims the benefit of priority of U.S. provisional application serial no. 61/767,502, filed February 21, 2013.

Field of the invention

This disclosure relates generally to batteries and more particularly to an electrochemical model for estimating the capacity of a lithium-ion battery system.

Background of the invention

Batteries are electrochemical energy storage devices that convert chemical energy into electrical energy. One particular type of battery is a lithium-ion ("Li-ion") battery. Lithium-ion batteries are desirable energy storage devices for portable electronics and electric and hybrid-electric vehicles, among other devices and systems, because of their high specific energy compared to other electrochemical energy storage devices.

Extended cycling (*i.e.* charging and discharging) of a lithium-ion battery typically results in a reduction of the energy storage capacity of the battery. This loss of capacity over time is referred to as capacity fade. For example, a lithium-ion battery having an initial capacity of 5000 mAh (milliamp-hours) exhibits a capacity of only 4000 mAh after 100 charge and discharge cycles. The reduction in capacity is attributable to a loss of active material, degradation of the electrodes, decomposition or loss of electrolyte, formation of films on the electrodes, increased impedance of the electrodes, and dissolution of the current collector, among other factors.

As a result of capacity fade (and other factors), capacity estimation of a lithium-ion battery is a challenging issue. Typically, the capacity of a lithium-ion battery is determined using a capacity estimation algorithm. These algorithms typically estimate the capacity of the battery based on factors such as a terminal voltage, a charge current, and/or a temperature of the battery. The capacity estimate formed from these types of algorithms is typically accurate enough for most applications; however, some devices, such as electric and hybrid-electric vehicles, require a more sophisticated capacity estimation technique that takes into account the effects of capacity fade.

For at least the above-described reasons further developments in the area of capacity estimation of a lithium-ion battery are desirable.

The following prior art documents D1-D3 disclose further technological background for the present invention:

D1    WO 2013/173610 A1 (BOSCH GMBH ROBERT [DE]; CHATURVEDI NALIN [US]; SCHOENLEBER MICHAEL [US]) 21 November 2013 (2013-11-21)
D2    EP 1 562 048 A1 (SONY CORP [JP]) 10 August 2005 (2005-08-10)
D3    US 2012/105068 A1 (WANG JOHN S [US] ET AL) 3 May 2012 (2012-05-03)

Document D1 (a document under Art. 54 (2) EPC) discloses an electrochemical battery system including a current sensor configured to generate a current signal, a voltage sensor configured to generate a voltage signal, a memory in which command instructions are stored, and a processor configured to execute the command instructions to obtain the current signal and the voltage signal, and to generate an estimated cell nominal capacity. An estimation of the nominal capacity is made during a first and second charging sequence of different current amplitudes.

Furthermore, document D2 discloses a battery capacity calculating method which is adapted to calculate a residual capacity of a second battery especially in the last stage of charging. The battery capacity calculating apparatus is equipped with a voltage measuring circuit which measures the terminal voltage of a battery at the time of charging, a current measuring circuit which measures the current value of the battery at the time of charging and a control circuit which calculates a residual capacity and/or a residual power. The operation unit in the control circuit calculates a discharged capacity and an apparent discharge capacity based on the terminal voltage and a current value measured by the voltage measuring circuit and the current measuring circuit, respectively. A discharge curve is subsequently estimated for the future including the last stage of discharging based on a capacity shift.

In addition, document D3 discloses a method for monitoring lithium-iron battery cells including a monitoring of the cell voltage and a corresponding state of charge of the battery cell during charge or discharge. The measured potential-derivative is determined by differentiating the battery cell voltage in relation to the corresponding state of charge of the battery during charge or discharge. A state of health parameter of the battery cell corresponding to the comparison of the measured potential-derivative with the preferred and old potential-derivative of the anode curve is determined.

Summarizing, documents D1-D3 disclose techniques for monitoring lithium-ion battery cells and methods for calculating the capacity of the battery cell in a last stage of discharging. However, even with regard to these techniques, more accurate results of the estimation would be desirable.

Therefore, the object of the present invention is to provide a method of estimating at least one parameter of a lithium-ion battery cell and a lithium-ion battery system which allow to estimate the capacity in a more sophisticated manner and more accurately.

This object is solved by a method according to claim 1 and by a battery system according to claim 10. Further advantageous embodiments and improvements of the invention are listed in the dependent claims.

Hereinafter, embodiments and examples of the present invention are described with reference to the drawings and the aspects of the invention listed below.

<u>Summary</u>

According to one embodiment of the disclosure, a method of estimating at least one parameter of a lithium-ion battery cell includes determining a terminal voltage ($V_{eq}$) of the lithium-ion battery cell during an equilibrium condition of the lithium-ion battery cell with a voltage sensor, and determining a charge current ($I$) of the lithium-ion battery cell during a charging operation of the lithium-ion battery cell with a current sensor. The method further includes using a parameter estimation technique to estimate at least one of a capacity ($C_O^+$) to store lithium ions of a positive electrode of the lithium-ion battery cell, a capacity ($C_O^-$) to store lithium ions of a negative electrode of the lithium-ion battery cell, and a total amount of lithium ions ($n_{Li}$) in the lithium-ion battery cell based on a model including the following formulae

$$\frac{d}{dt}SOC^- = \frac{I}{C_0^-},$$

$$V_{eq}\left(SOC^-\right) = \overline{U}^+\left(\frac{n_{Li}}{C_0^+}-\frac{C_0^-}{C_0^+}SOC^-\right)-\overline{U}^-\left(SOC^-\right),$$

wherein "$SOC^-$" is a state of charge of the negative electrode, "$\overline{U}^+$" is an average open circuit potential of the positive electrode during the equilibrium condition, and "$\overline{U}^-$" is an average open circuit potential of the negative electrode during the equilibrium condition. Also, the method includes generating an output corresponding to the estimate of at least one of the capacity ($C_O^+$) to store lithium ions of the positive electrode, the capacity ($C_O^-$) to store lithium ions of the negative electrode, and the total amount of lithium ions ($n_{Li}$).

According to another embodiment of the disclosure, a lithium-ion battery system includes at least one lithium-ion battery cell, a voltage sensor, a current sensor, a memory, and a processor. The lithium-ion battery cell includes a positive electrode and a negative electrode. The voltage sensor is configured to generate a voltage signal representative of a voltage between the positive electrode and the negative electrode during an equilibrium condition of the at least one lithium-ion battery cell. The current sensor is configured to generate a current signal representative of a current associated with the lithium-ion battery cell. The memory is configured to store command instructions. The processor is configured to execute the command instructions to use a parameter estimation technique to estimate at least one of a capacity ($C_O^+$) to store lithium ions of the positive electrode, a capacity ($C_O^-$) to store lithium ions of the negative electrode, and a total amount of lithium ions ($n_{Li}$) in the lithium-ion battery cell based on a model including the following formulae

$$\frac{d}{dt}SOC^- = \frac{I}{C_0^-},$$

*and*

$$V_{eq}\left(SOC^-\right) = \overline{U}^+\left(\frac{n_{Li}}{C_0^+}-\frac{C_0^-}{C_0^+}SOC^-\right)-\overline{U}^-\left(SOC^-\right),$$

wherein "$SOC^-$" is a state of charge of the negative electrode, "$\overline{U}^+$" is an average open circuit potential of the positive

electrode, and "$\overline{U^-}$" is an average open circuit potential of the negative electrode.

Brief Description of the Figures

The above-described features and advantages, as well as others, should become more readily apparent to those of ordinary skill in the art by reference to the following detailed description and the accompanying figures in which:

FIG. 1 depicts a schematic of a battery system including a lithium-ion cell, a processor, and a memory;
FIG. 2 depicts a spherical model of active material in electrodes of the battery system of FIG. 1;
FIG. 3 depicts an amount of lithium ions stored by each electrode of the battery system of FIG. 1; and
FIG. 4 depicts a flowchart showing an exemplary method of operating the battery system of FIG. 1.

Detailed Description

For the purpose of promoting an understanding of the principles of the disclosure, reference will now be made to the embodiments illustrated in the drawings and described in the following written specification. It is understood that no limitation to the scope of the disclosure is thereby intended. It is further understood that this disclosure includes any alterations and modifications to the illustrated embodiments and includes further applications of the principles of the disclosure as would normally occur to one skilled in the art to which this disclosure pertains.

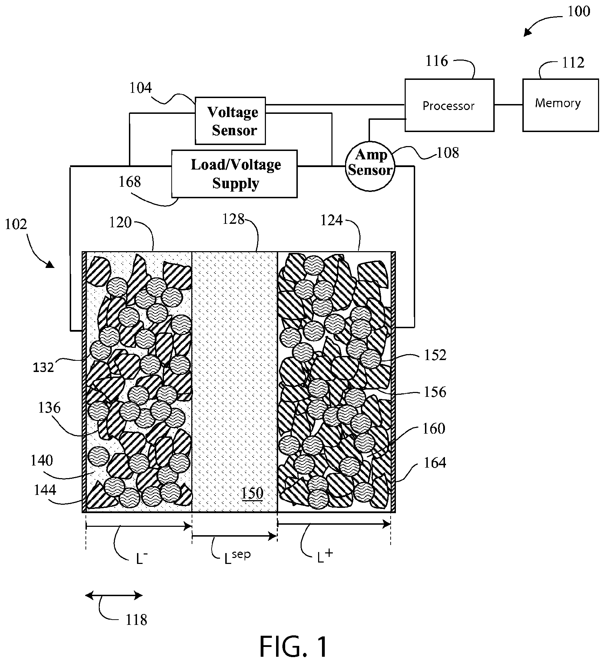

FIG. 1 depicts a lithium-ion battery system 100 including at least one lithium-ion battery cell referred to herein as a lithium-ion cell 102, a voltage sensor 104, a current sensor 108 (denoted "amp sensor" in FIG. 1), a memory 112 configured to store command instructions, and a processor 116. A schematic representation of the lithium-ion cell 102 is shown, in FIG. 1. In particular, the illustrated representation of the lithium-ion cell 102, is referred to as a macro-homogenous 1D-spatial model that is shown extending along an axis 118. While only one lithium-ion cell 102 is shown, in another embodiment the system 100 includes more than one cell 102.

The lithium-ion cell 102, which is also referred to herein as an "Li-ion cell," includes a negative electrode 120, a positive electrode 124, and a separator region 128 located between the negative electrode and the positive electrode. The negative electrode 120 includes at least one active material 132, an inert material(s) 136, an electrolyte 140, and a current collector 144. The negative electrode 120 extends for a length $L^-$ along the axis 118.

The active material 132 is a material into which lithium ions ("$Li^+$") can be inserted. Accordingly, the active material 132 is also referred to herein as a "lithium-insertion material." Exemplary material for forming the active material 132 includes, for example, graphite, disordered carbon, and/or lithium titanate, among other materials as desired by those of ordinary skill in the art. At least a portion of the active material 132 is in the solid phase and is referred to herein as the solid phase portion of the active material 132.

The inert material 136 includes, for example, a polymeric binder (e.g., polyvinyldifluoride ("PVDF")) and/or a carbon additive for conduction (e.g., acetylene black, graphite, and/or carbon fiber).

The electrolyte 140 is configured to fill any spaces between the active material 132 and the inert material 136. The electrolyte 140 includes, for example, Lithium Hexafluorophosphate ("LiPF6") in a non-aqueous electrolyte, a cyclic carbonate (e.g., ethylene carbonate and propylene carbonate), a linear carbonate (e.g., dimethyl carbonate, ethyl methyl carbonate, and diethyl carbonate), an organic solvent (e.g., acetonitrile), a polymer electrolyte (e.g., polyethylene oxide), and/or any other suitable electrolyte, as desired by those of ordinary skill in the art.

The current collector 144 is configured to form a negative terminal (*i.e.* anode) of the lithium-ion cell 102 during discharge of the lithium-ion cell. The current collector 144 is positioned to contact the electrolyte 140. The current collector 144 includes, for example, copper. Alternatively, the current collector 144 includes any other metal, as desired by those of ordinary skill in the art.

The separator region 128 is configured to serve as a physical barrier between the negative electrode 120 and the positive electrode 124 so that neither electrode 120, 124 is electronically connected within the lithium-ion cell 102. The separator region 128 includes, for example, an electrolyte 150 including a lithium cation. Accordingly, the separator region 128 allows transfer of lithium ions between the negative electrode 120 and the positive electrode 124. The separator region 128 extends for a length $L^{sep}$ along the axis 118.

The positive electrode 124 includes at least one active material 152, an inert material 156, an electrolyte 160, and a current collector 164 and is configured to extend for a length $L^+$ along the axis 118. The active material 152 includes a transition metal oxide, such as lithium manganese oxide; a lithium metal phosphate, such as lithium iron phosphate; and/or another material as desired by those of ordinary skill in the art. At least a portion of the active material 152 is in the solid phase and is referred to herein as the solid phase portion of the active material 152.

The inert material 156 is formed from, for example, a polymeric binder (e.g., polyvinyldifluoride ("PVDF")) and/or a carbon additive for conduction (e.g., acetylene black, graphite and/or carbon fiber).

The electrolyte 160 is formed from, for example, Lithium Hexafluorophosphate ("LiPF6") in a non-aqueous electrolyte, a cyclic carbonate (e.g., ethylene carbonate and propylene carbonate), a linear carbonate (*e.g.,* dimethyl carbonate, ethyl methyl carbonate, and diethyl carbonate), an organic solvent (*e.g.,* acetonitrile), a polymer electrolyte (*e.g.,* polyethylene oxide), and/or any other material as desired by those of ordinary skill in the art.

The current collector 164 is configured to form a positive terminal (*i.e.* cathode) of the lithium-ion cell 102 during discharge of the lithium-ion cell. The current collector 164 is positioned to contact the electrolyte 160. The current collector 164 includes, for example, aluminum. Alternatively, the current collector 164 includes any other metal as desired by those of ordinary skill in the art.

The voltage sensor 104 is connected to the negative electrode 120 and the positive electrode 124 and is configured to sense a difference in electrical potential between the positive electrode 124 and the negative electrode 120. The voltage sensor 104 is any suitable circuit, including any of a plurality of well-known forms, which is configured to generate an electrical signal representative/indicative of a voltage between the positive electrode 124 and the negative electrode 120. For example, in one embodiment the voltage sensor 104 includes a resistive voltage divider circuit.

With continued reference to FIG. 1, the current sensor 108 is connected in series with a load / voltage supply 168 and the positive electrode 124. The current sensor 108 is configured to generate an electrical signal representative/indicative of the current associated with the lithium-ion cell 102. When the lithium-ion cell 102 is being charged, the current sensor 108 is configured to generate an electrical signal representative of a charge current "*I*" associated with the lithium-ion cell 102. The current sensor 108 is any suitable circuit for sensing current, including any of a plurality of well-known forms.

The processor 116 is connected to the voltage sensor 104, the current sensor 108, and the memory 112. The processor 116 is operable to execute the command instructions programmed into the memory 112 in order to estimate a capacity (among other parameters) of the lithium-ion cell 102, according to a model described in detail below. The processor 116 is any type of processor as desired by those of ordinary skill in the art.

The lithium-ion cell 102 is connected to at least one load and/or at least one voltage supply, as represented schematically by the load / voltage supply 168. When the lithium-ion cell 102 is being discharged, the load / voltage supply 168 represents a load. When the lithium-ion cell 102 is being charged, the load / voltage supply 168 represents a voltage supply. The load / voltage supply 168 is representative of any type of load and/or voltage supply that one of ordinary skill in the art desires to connect to the lithium-ion cell 102.

The lithium-ion cell 102 operates in a manner similar to the lithium-ion battery cell disclosed in U.S. Patent No. 7,726,975, which issued June 1, 2010. In particular, during discharging of the lithium-ion cell 102, electrons are generated at the negative electrode 120 due to extraction via oxidation of lithium ions from the active material 132, and electrons are consumed at the positive electrode 124 due to reduction of lithium ions into the active material 152. During charging of the lithium-ion cell 102, the reactions are reversed, with lithium ions and electrons moving from the positive electrode 124 to the negative electrode 120.

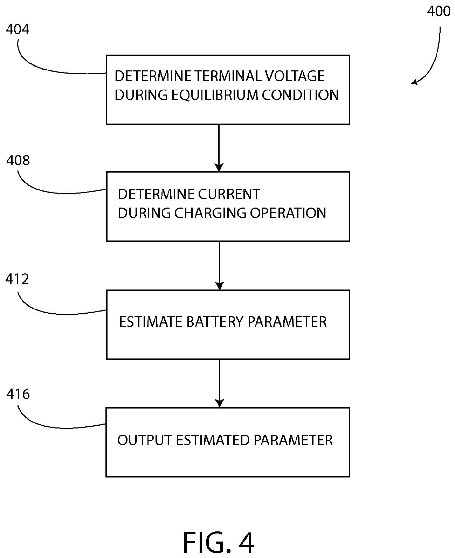

As a result of repeated cycling, the lithium-ion cell 102 typically exhibits capacity fade. As previously described, capacity fade increases the difficulty with which the capacity of the lithium-ion cell 102 is determined, because capacity fade causes the capacity to change over the cell's 102 lifetime. Accordingly, a capacity estimation method 400 (FIG. 4) based on an electrochemical model of the lithium-ion cell 102 is used to accurately determine the capacity of the lithium-ion cell at any time during the lithium-ion cell's lifetime.

The electrochemical model includes distributed state variables such as: a current $i_s(x,t)$ in the solid phase portions of the electrodes 120, 124; a current $i_e(x,t)$ in the electrolyte; an electric potential $\Phi_s(x,t)$ in the solid phase portions of the electrodes 120, 124; a molar flux density $j_{n,i}(x,t)$ from the surface of the active material(s) to the electrolyte; a concentration $c_e(x,t)$ of lithium ions in the electrolyte phase; and a concentration $c_s(x,r,t)$ of lithium ions in the solid phase portions of the electrodes 120, 124.

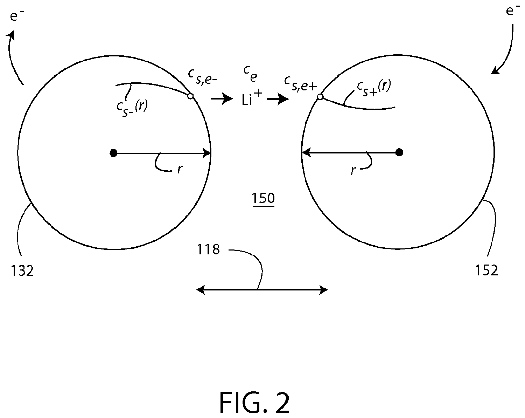

With reference to FIG. 2, the electrochemical model is based on the negative electrode 120 and the positive electrode 124 including numerous spherically shaped particles of the active material 132, 152. The electrochemical model is also based on the electrochemical reaction occurring at the surface of the spherically shaped particles of the active material 132, 152, as shown graphically in FIG. 2. For example, the concentration of lithium ions in the solid phase portions of the electrodes (*i.e.* $c_s(x,r,t)$) is taken at a distance "*r*" from the center of the spherical particle of active material 132, 152, located at position "*x*" in the electrode, and at time "*t*."

The input to the electrochemical model is an applied current $I(t)$, and the output of the model is a voltage $V(t)$. The voltage $V(t)$ represents a difference between a potential $\Phi_s^+$ of the positive electrode 124 and a potential $\Phi_s^-$ of the negative electrode 120, as shown in the following equation:

$$V(t) = \Phi_s^+\left(0^+, t\right) - \Phi_s^-\left(0^-, t\right)$$

According to the distributed state variables defined above, the electrochemical model of the lithium-ion cell 102 is given by the equations listed below.

$$\frac{\partial c_s}{\partial t}(x,r,t) = \frac{D_s}{r^2}\frac{\partial}{\partial r}\left[r^2\frac{\partial c_s}{\partial r}(x,r,t)\right] \qquad (1)$$

$$\frac{\partial c_s}{\partial r}(x,0,t) = 0 \ , \quad \frac{\partial c_s}{\partial r}(x,R_p,t) = -\frac{1}{D_s}j_n(x,t) \qquad (2)$$

$$\frac{\partial c_e}{\partial t}(x,t) = \frac{\partial}{\partial x}\left[D_e\frac{\partial c_e}{\partial x}(x,t) + \frac{1-t_c^0}{\varepsilon_e F}i_e(x,t)\right] \qquad (3)$$

$$\varepsilon_e^- D_e\frac{\partial c_e}{\partial x}(0^-,t) = 0, \quad \varepsilon_e^+ D_e\frac{\partial c_e}{\partial x}(0^+,t) = 0, \qquad (4)$$

$$\varepsilon_e^{sep} D_e\frac{\partial c_e}{\partial x}(0^{sep},t) = \varepsilon_e^- D_e\frac{\partial c_e}{\partial x}(L^-,t) \qquad (5)$$

$$\varepsilon_e^{sep} D_e\frac{\partial c_e}{\partial x}(L^{sep},t) = -\varepsilon_e^+ D_e\frac{\partial c_e}{\partial x}(L^+,t) \qquad (6)$$

$$\frac{\partial \varphi_s}{\partial x}(x,t) = \frac{i_e(x,t)-I(t)}{\sigma} \qquad (7)$$

$$\frac{\partial \Phi_e}{\partial x}(x,t) = -\frac{i_e(x,t)}{\kappa} + \frac{2RT}{F}\left(1-t_c^0\right)\left(1+\frac{d\ln f_{c/a}(x,t)}{d\ln c_e(x,t)}\right)\frac{\partial \ln c_e}{\partial x}(x,t) \qquad (8)$$

$$\Phi_e(0^+,t) = 0 \qquad (9)$$

$$\frac{\partial i_e}{\partial x}(x,t) = a_s F j_n(x,t) \qquad (10)$$

$$i_e^-(0^-,t) = 0, \quad i_e^-(0^+,t) = 0, \quad i_e^-(L^-) = -I(t), \quad i_e^+(L^+) = I(t) \qquad (11)$$

$$\rho^{avg} C_p\frac{dT}{dt}(t) = h_{cell}\left(T_{amb}(t)-T(t)\right) + I(t)V(t) - \int_{0^-}^{0^+} a_s F j_n(x,t)\left[U(\bar{c}_s(x,t)) - T(t)\frac{\partial U(\bar{c}_s)}{\partial T}(x,t)\right]dx \qquad (12)$$

$$j_n(x,t) = \frac{1}{F} i_0(x,t) \sinh\left[\frac{\alpha F}{RT} \eta(x,t)\right]; \ j_n(x^{sep},t) = 0) \qquad (13)$$

$$i_0(x,t) = r_{eff} \sqrt{c_e(x,t) c_{ss}(x,t)(c_{s,\max} - c_{ss}(x,t))} \qquad (14)$$

$$\eta(x,t) = \varphi_s(x,t) - \varphi_e(x,t) - U(c_{ss}(x,t)) - FR_f j_n(x,t) \qquad (15)$$

$$c_{ss}(x,t) = c_s(x,R_p,t)) \qquad (16)$$

The variables in the above equations correspond to the following:

"$a_s$" is a specific surface area of the electrodes 120, 124,
"$c_e$" is a concentration of lithium ions per unit volume in the electrolyte phase,
"$c_s$" is a concentration of lithium ions per unit volume,
"$c_{s,max}$" is a maximum concentration of lithium ions per unit volume,
"$c_{ss}$" is a steady state (*i.e.* equilibrium condition) concentration of lithium ions per unit volume,
"$c_p$" is a concentration of lithium ions per unit volume,
"$D_e$" is an electrolyte phase lithium ion diffusion coefficient [cm$^2$/s],
"$D_s$" is a solid phase lithium ion diffusion coefficient [cm$^2$/s],
"$F$" is Faraday's constant,
"$i_e$" is a current through the electrolyte 140, 150, 160,
"$i_e^-$" is a current through the electrolyte 140,
"$i_e^{sep}$" is a current through the electrolyte 150,
"$i_e^+$" is a current through the electrolyte 160,
"$I(t)$" is a charge current,
"$j_n$" is a molar flux density,
"$r$" is a distance from the center of the spherical particle of active material 132, 152,
"$R$" is the universal gas constant,
"$R_p$" is a radius of the active material 132, 152 particles,
"$t$" is time,
"$t_c^0$" is a lithium ion transfer number,
"$T$" is a temperature,
"$T_{amb}$" is an ambient temperature,
"$U$" is an equilibrium potential of an electrode reaction,
"$V(t)$" is a terminal voltage,
"$x$" is a distance measured in the axis 118,
"$x^{sep}$" is a length of the separator region 128 as measured in the axis 118,
"$\varepsilon_e$" is a volume fraction of the electrolyte 140, 150, 160,
"$\varepsilon_e^-$" is a volume fraction of the electrolyte 140,
"$\varepsilon_e^{sep}$" is a volume fraction of the electrolyte 150,
"$\varepsilon_e^+$" is a volume fraction of the electrolyte 160,
"$\eta$" is the overpotential of an electrode reaction,
"$\kappa$" is the lithium ion conductivity of electrolyte 140, 150, 160,
"$\sigma$" is an electron conductivity of electrode solid matrix,
"$\Phi_e$" is the potential of the electrolyte 140, 150, 160,
"$\varphi_s$" is the phase potential of lithium ions in the solid phase, and
"$\varphi_e$" is the phase potential of lithium ions in the electrolyte phase.

Based on the above equations a model is developed herein that is configured to determine a capacity "$C_0^-$" of the negative electrode 120 for storing lithium ions, a capacity "$C_0^+$" of the positive electrode 124 for storing lithium ions, and a total number of lithium ions "$n_{Li}$" (measured in moles and referred to as "total lithium content") in the lithium-ion cell 102.

The model includes determining a terminal voltage "$V_{eq}$" of the lithium-ion cell 102 during an equilibrium condition of the lithium-ion cell. The equilibrium condition is a condition of the lithium-ion cell 102 in which the cell 102 has not been charged or discharged for a period of time that is sufficient to cause the surface concentration of lithium ions in the active material 132, 152 to correspond to the average concentration of lithium ions in the active material 132, 152. Accordingly, during the equilibrium condition the total lithium content "$n_{Li}$" is given by the following equation.

$$n_{Li} = \varepsilon_s^- L^- c_s^{-,eq} + \varepsilon_s^+ L^+ c_s^{+,eq} \quad (17)$$

From the above equation, the total lithium content is based on a volume fraction "$\varepsilon_s^-$" of the active material 132 in the negative electrode 120, the length "$L^-$" along the axis 118 of the negative electrode 120, a concentration "$c_s^{-,eq}$" of lithium ions in the negative electrode 120, a volume fraction "$\varepsilon_s^+$" of the active material 152 in the positive electrode 124, the length "$L^+$" along the axis 118 of the positive electrode 124, and a concentration "$c_s^{+,eq}$" of lithium ions in the positive electrode 120.

Next, the total lithium content "$n_{Li}$" of the lithium-ion cell 102 based on the state of charge "$SOC$" of the individual electrodes 120, 124 is described. Based on equation (17), the capacities "$C_0^+$", "$C_0^-$" of the positive electrode 124 and the negative electrode 120 are given by the following equation.

$$C_0^+ = \varepsilon_s^+ L^+ c_s^{+,\max}, \quad C_0^- = \varepsilon_s^- L^- c_s^{-,\max} \quad (18)$$

The capacity "$C_0^+$" of the positive electrode 124 is based on the volume fraction "$\varepsilon_s^+$" of the active material 152 in the positive electrode 124 the length "$L^+$" along the axis 118 of the positive electrode 124, and the maximum concentration "$c_s^{+,max}$" of the positive electrode 120. The capacity "$C_0^-$" of the negative electrode 120 is based on the volume fraction "$\varepsilon_s^-$" of the active material 152 in the negative electrode 120, the length "$L^-$" along the axis 118 of the negative electrode 120, and the maximum concentration "$c_s^{-,max}$" of the negative electrode 120. The maximum concentrations "$c_s^{-,max}$" and "$c_s^{+,max}$", represent the maximum number of lithium ions per unit volume that the negative electrode 120 and the positive electrode 124 are capable of storing.

The state of charge "$SOC^-$" of the negative electrode 120 during the equilibrium condition and the state of charge "$SOC^+$" of the positive electrode 124 during the equilibrium condition is a function of the concentration of lithium ions in each respective electrode 120, 124. The states of charge "$SOC^-$", "$SOC^+$" of the individual electrodes 120, 124 at the equilibrium condition is described according to the following equations.

$$SOC^- = \frac{c_s^{-,eq}}{c_s^{-,\max}}, SOC^+ = \frac{c_s^{+,eq}}{c_s^{+,\max}} \quad (19)$$

Equation (19) is a constraint on the lithium-ion cell 102; accordingly, if the parameters of the cell 102 are known, then knowledge of SOC$^-$ is used to determine SOC$^+$. Equations (18) and (19) are substituted into equation (17) to arrive at the following equation describing the total lithium content "$n_{Li}$".

$$n_{Li} = C_0^+ SOC^+ + C_0^- SOC^- \quad (20)$$

Based on equation (20) the total lithium content is equal to the capacity "$C_0^+$" of the positive electrode 124 times the state of charge "SOC$^+$" of the positive electrode 124 plus the capacity "$C_0^-$" of the negative electrode 120 times the state of charge "SOC$^-$" of the negative electrode 120.

To further develop the model, next, the open circuit potential "U$^-$" of the negative electrode 120 and the open circuit potential "U$^+$" of the positive electrode 124 are considered. The open circuit potentials U$^-$, U$^+$ are described herein as functions of the lithium ion concentrations in the respective electrodes 120, 124. Accordingly, during the equilibrium condition, the terminal voltage "$V_{eq}$" is described as the open circuit potential "$U^+$" of the positive electrode 124 minus the open circuit potential "$U^-$" of the negative electrode 120, as shown in equation (21).

$$V_{eq}\left(c_s^{+,eq}, c_s^{-,eq}\right) = U^+\left(c_s^{+,eq}\right) - U^-\left(c_s^{-,eq}\right) \quad (21)$$

Based on the above relationships and equations, the model is further developed by substituting equation (19) into equation (21), as shown below.

$$V_{eq}\left(SOC^+ c_s^{+,\max}, SOC^- c_s^{-,\max}\right) = U^+\left(SOC^+ c_s^{+,\max}\right) - U^-\left(SOC^- c_s^{-,\max}\right) \quad (22)$$

During the equilibrium condition, equation (22) is simplified to the following equation (23).

$$V_{eq}\left(SOC^+, SOC^-\right) = \overline{U}^+\left(SOC^+\right) - \overline{U}^-\left(SOC^-\right) \quad (23)$$

In equation (23) the terminal voltage during the equilibrium condition "$V_{eq}$" is equal to the average open circuit potential "$\overline{U}^+$" of the positive electrode 124 during the equilibrium condition as a function of the state of charge "$SOC^+$" of the positive electrode 124 minus the average open circuit potential "$\overline{U}^-$" of the negative electrode 120 during the equilibrium condition as a function of the state of charge "$SOC^-$" of the negative electrode 120.

Additionally, the model is further developed by noting that the state of charge "$SOC^-$" of the negative electrode 120 is based on a given charge current "$I$" by the following equation (24), where the charge current "$I$" is positive during charging of the lithium-ion cell 102.

$$\frac{d}{dt}SOC^- = \frac{I}{C_0^-} \quad (24)$$

In equation (24), the derivative with respect to time of the state of charge "$SOC^-$" of the negative electrode 120 is equal to the charge current "$I$" divided by the capacity "$C_0^-$" of the negative electrode 120.

Consolidation of the above derived equations yields the model that is usable to determine the capacity "$C_0^-$" of the negative electrode 120, the capacity "$C_0^+$" of the positive electrode 124, and the total lithium content "$n_{Li}$" of the lithium-ion cell 102. The model includes at least the following two equations (24) and (25).

$$\frac{d}{dt}SOC^- = \frac{I}{C_0^-} \quad (24)$$

$$V_{eq}\left(SOC^-\right) = \overline{U}^+\left(\frac{n_{Li}}{C_0^+} - \frac{C_0^-}{C_0^+}SOC^-\right) - \overline{U}^-\left(SOC^-\right) \quad (25)$$

With the above equations (24) and (25), a parameter estimation technique can be applied to estimate the capacity "$C_0^-$" of the negative electrode 120, the capacity "$C_0^+$" of the positive electrode 124, and the total lithium content "$n_{Li}$".

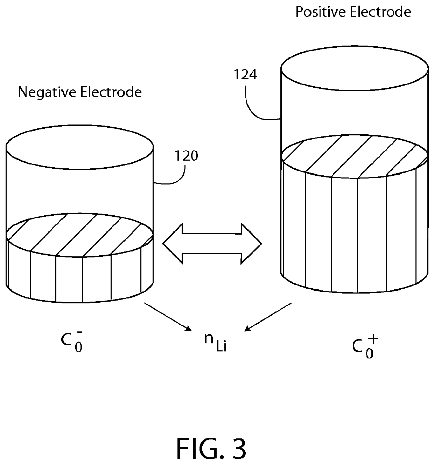

As shown in FIG. 3, the model is further developed to determine the capacity "$C_0$" of the lithium-ion cell 102. Specifically, after the parameter estimation technique has been applied to the equations (24) and (25), the estimated parameters ("$C_0^-$", "$C_0^+$", and "$n_{Li}$") are usable to determine a total capacity "$C_0$" of the lithium-ion cell 102. The total capacity "$C_0$" determined according to the following equation.

$$C_0 = \min\left(C_0^+, C_0^-, n_{Li}, C_0^+ + C_0^- - n_{Li}\right) \quad (26)$$

Based on the above equation the total capacity "$C_0$" is equal to the minimum of (i) the capacity "$C_0^+$" of the positive electrode 124, (ii) the capacity "$C_0^-$" of the negative electrode 120, (iii) the total lithium content "$n_{Li}$", and (iv) the capacity "$C_0^+$" of the positive electrode 124 plus the capacity "$C_0^-$" of the negative electrode 120 minus the total lithium content "$n_{Li}$".

The system 100 is configured to use the above described model to determine the estimated parameters (*i.e.* "$C_0^-$", "$C_0^+$", and "$n_{Li}$") according to the method 400 of FIG. 4. In block 404, the system 100 is configured to determine the terminal voltage "$V_{eq}$" during the equilibrium condition. The lithium-ion cell 102 is in the equilibrium condition when, for the duration of a predetermined time period, the lithium-ion cell (i) has not been charged and (ii) has not supplied a current to a load 168. The length of the predetermined time period depends on the structure of the lithium-ion cell 102 and ranges from ten minutes to two hours. An exemplary predetermined time period is approximately fifteen minutes. The system 100 stores the length of the predetermined time period in the memory 112, and the processor 116 determines if the lithium-ion cell 102 is in the equilibrium condition.

After the lithium-ion cell 102 is in the equilibrium condition, the system 100 uses the voltage sensor 104 to determine the terminal voltage "$V_{eq}$" of the lithium-ion cell 102 during the equilibrium condition. The terminal voltage "$V_{eq}$" sensed by the voltage sensor 104 is stored in the memory 112.

Next, in block 408 of FIG. 4, the system 100 determines the charge current "$I$" during a charging operation of the cell 102. During the charging operation, the load/voltage supply 168 represents a voltage source having a terminal voltage with a magnitude that is greater than the terminal voltage "$V_{eq}$", such that the charge current "$I$" flows through the lithium-ion cell 102. The charge current "$I$" is measured by the amp sensor 108 and is stored in the memory 112. Depending on the configuration of the system 100, the processor 116 stops the charging operation after determining the charge current "$I$", or the processor continues the charging operation until the lithium-ion cell 102 has reached a desired charge level.

Next, as shown in block 412, the processor 116 determines the capacity "$C_0^-$" of the negative electrode 120, the capacity "$C_0^+$" of the positive electrode 124, and the total lithium content "$n_{Li}$" of the lithium-ion cell 102 (referred to collectively as the estimated parameters). In particular, the processor 116 uses the measured terminal voltage "$V_{eq}$" during the equilibrium condition, the measured charge current "$I$" during the charging operation, and the above described model (*i.e.* at least equations (24) and (25)) to determine the estimated parameters.

To determine the estimated parameters, the processor 116 applies at least one parameter estimation technique to the above described model. Exemplary parameter estimation techniques include nonlinear-least squares, nonlinear Luenberger observer design, and extended Kalman Filter. The processor 116 is configured to apply any parameter estimation technique to the above descried model in order to determine the estimated parameters.

In block 416 of the method 400, the processor 116 generates an output corresponding to at least one of the estimated parameters. The output is sent to a video display (not shown) or any other interface on which data is displayable. The output is used, for example, to update or change a prior showing of the capacity (*i.e.* "$C_0^-$", "$C_0^+$", and "$n_{Li}$") of the lithium-ion cell 102 to an updated showing of the capacity of the lithium-ion cell. The estimated parameters capture aging of the lithium-ion cell 102 and enable the processor 116 to determine an accurate capacity of the lithium-ion cell 102 that takes into account the effects of capacity fade.

In the above determination of the estimated parameters, the state of charge "SOC$^-$" of the negative electrode 120 is known. If, however, the state of charge "SOC$^-$" of the negative electrode 120 is not known, the above described model is then discretized to enable the processor to determine a sufficiently accurate value of "SOC$^-$". The discretized model includes the following equations.

$$SOC^-(k+1) = SOC^-(k) + \frac{I}{C_0^-}T_s \quad (27)$$

$$V_{eq}(SOC^-(k)) = \overline{U}^+\left(\frac{n_{Li}}{C_0^+} - \frac{C_0^-}{C_0^+}SOC^-(k)\right) - \overline{U}^-(SOC^-(k)) \quad (28)$$

In the above equations, the variable "$k$" represents a time step in the discrete system and the notation ($k$+1) refers to the next time step after time step "$k$". Also, "$T_s$" refers to a temperature of the lithium-ion cell 102.

With the above discretized model, an optimization problem is formulated including the following find parameters $\{SOC^-(0), n_{Li}, C_0^+, C_0^-\}$ that

$$\min \quad \left(\left(V_{eq}\left(SOC^-(k)\right)-V_{meas}(k)\right)^2\right)$$

such that

$$SOC^-(k) \quad = \quad SOC^-(k)+\frac{I}{C_0^-}T_s, \qquad (29)$$

$$V_{eq}\left(SOC^-(k)\right) \quad = \quad \overline{U}^+\left(\frac{n_{Li}}{C_0^+}-\frac{C_0^-}{C_0^+}SOC^-(k)\right)-\overline{U}^-\left(SOC^-(k)\right).$$

In the above optimization problem (29) "$V_{meas}$" is another terminal voltage of the lithium-ion cell 102.

The above optimization problem (29) is solvable using various techniques as desired by those of ordinary skill in the art. Exemplary techniques include batch optimization and recursion-based methods. Additionally, the optimization problem (29) is solvable using an approach in which the parameters $\{SOC^-(0), n_{Li}, C_0^+, C_0^-\}$ are treated as states of the model in equations (27) and (28) where the states $\{n_{Li}, C_0^+, C_0^-\}$ are treated as constant. Then an observer design technique such as Extended Kalman Filter, particle filtering, and the like is used to estimate the parameters in real time.

In the above description, the positive electrode 124 and the negative electrode 120 are described as including only a single type of the active material 132, 152. In some electrochemical cells (not shown) the electrodes include more than one type of active material, each of which is configured to store lithium ions. The processor 116 is configured to use the model to determine the estimated parameters of a cell that includes more than one type of active material in the positive electrode and the negative electrode. In particular, the processor 116 uses the parameter estimation technique for each active material in the electrodes 120, 124.

When determining the estimated parameters of a cell that includes more than one type of active material, the processor 116 performs a summation over each type of active material to determine the total amount of lithium ions "$n_{Li}$" in the lithium-ion cell 102, according to the below equation.

$$n_{Li} = \sum_{i=1}^{n^-}\varepsilon_{s,i}^- L^- c_{s,i}^{-,*} + \sum_{i=1}^{n^+}\varepsilon_{s,i}^+ L^+ c_{s,i}^{+,*} \quad (30)$$

In equation (30), each active material is numbered from 1 to "n", and the summation is performed from 1 to "n." The total amount of lithium "$n_{Li}$" is based on a volume fraction "$\varepsilon_{s,i}^-$" of the "$i^{th}$" active material in the negative electrode, the length "$L^-$" along an axis of the negative electrode, the concentration "$c_{s,i}^{-,*}$" of the "$i^{th}$" active material in the negative electrode, a volume fraction "$\varepsilon_{s,i}^+$" of the "$i^{th}$" active material in the positive electrode, the concentration "$c_{s,i}^{+,*}$" of the "$i^{th}$" active material in the positive electrode, and the length "$L^+$" along an axis of the positive electrode. In a cell that includes more than one type of active material it is noted that the multiple active materials result in the additional constraint of an equilibrium voltage between the different materials. In response to the aforementioned additional constraint, equation (30) includes an asterisk "*" indicating that the concentrations are determined at a particular equilibrium condition between the active materials.

While the disclosure has been illustrated and described in detail in the drawings and foregoing description, the same should be considered as illustrative and not restrictive in character.

**Claims**

**1.** A method of estimating at least one parameter of a lithium-ion battery cell (102), comprising:

a) determining a terminal voltage ($V_{eq}$) of the lithium-ion battery cell during an equilibrium condition of the lithium-ion battery cell with a voltage sensor (104);
b) determining a charge current ($I$) of the lithium-ion battery cell during a charging operation of the lithium-ion battery cell with a current sensor (108); and

c) using a parameter estimation technique to estimate at least one of a capacity $(C_O^+)$ to store lithium ions of a positive electrode (124) of the lithium-ion battery cell, a capacity $(C_O^-)$ to store lithium ions of a negative electrode (120) of the lithium-ion battery cell, and a total amount of lithium ions $(n_{Li})$ in the lithium-ion battery cell based on a model including the following formulae

$$\frac{d}{dt} SOC^- \quad = \quad \frac{I}{C_0^-},$$

$$V_{eq}\left(SOC^-\right) \quad = \quad \overline{U}^+\left(\frac{n_{Li}}{C_0^+} - \frac{C_0^-}{C_0^+} SOC^-\right) - \overline{U}^-\left(SOC^-\right),$$

wherein

"$SOC^-$" is a state of charge of the negative electrode,
"$\overline{U}^+$" is an average open circuit potential of the positive electrode during the equilibrium condition, and
"$\overline{U}^-$" is an average open circuit potential of the negative electrode during the equilibrium condition; and

d) generating an output corresponding to the estimate of at least one of the capacity $(C_O^+)$ to store lithium ions of the positive electrode, the capacity $(C_O^-)$ to store lithium ions of the negative electrode, and the total amount of lithium ions $(n_{Li})$.

2. The method of claim 1, further comprising:

estimating a total capacity $(C_0)$ of the lithium-ion battery cell according to the following formula

$$C_0 = \min\left(C_0^+, C_0^-, n_{Li}, C_0^+ + C_0^- - n_{Li}\right).$$

3. The method of claim 1, wherein the parameter estimation technique is one of nonlinear-least squares, nonlinear Luenberger observer design, and extended Kalman Filter.

4. The method of claim 1, further comprising:

determining the state of charge of the negative electrode ($SOC^-$) of the lithium-ion battery cell according to a discretized model including the following formulae

$$SOC^-(k+1) \quad = \quad SOC^-(k) + \frac{I}{C_0^-} T_s,$$

$$V_{eq}\left(SOC^-(k)\right) \quad = \quad \overline{U}^+\left(\frac{n_{Li}}{C_0^+} - \frac{C_0^-}{C_0^+} SOC^-(k)\right) - \overline{U}^-\left(SOC^-(k)\right),$$

wherein
"$T_S$" is a temperature of the lithium-ion battery cell.

5. The method of claim 4, further comprising:

determining the state of charge of the negative electrode ($SOC^-$) according to an optimization problem approach to solve a discretized model including the following formulae

$$\min \quad \left(\left(V_{eq}\left(SOC^-(k)\right)-V_{meas}(k)\right)^2\right),$$

such that,

$$SOC^-(k) \quad = \quad SOC^-(k)+\frac{I}{C_0^-}T_s,$$

and

$$V_{eq}\left(SOC^-(k)\right) \quad = \quad \overline{U}^+\left(\frac{n_{Li}}{C_0^+}-\frac{C_0^-}{C_0^+}SOC^-(k)\right)-\overline{U}^-\left(SOC^-(k)\right),$$

wherein "$V_{meas}$" is another terminal voltage of the lithium-ion battery cell.

6. The method of claim 5, wherein:

$SOC^-(0)$, $n_{Li}$, $C_0^+$, and $C_0^-$ are a plurality of states of the discretized model,

the states $n_{Li}$, $C_0^+$, and $C_0^-$ of the plurality of states are constant states of the discretized model, and

the method further comprises estimating at least one state of the plurality of states in real-time using an observer design technique including at least one of extended Kalman filter and particle filtering.

7. The method of claim 6, wherein the optimization problem approach includes at least one of a batch optimization and a recursion-based optimization.

8. The method of claim 1, wherein:

the positive electrode includes a plurality of active materials,
the negative electrode includes the plurality of active materials,
each active material of the plurality of active materials is configured to store lithium ions, and
using the parameter estimation technique includes using the parameter estimation technique for each active material of the plurality of active materials.

9. The method of claim 8, wherein the total amount of lithium ions ($n_{Li}$ is determined based on the following formula

$$n_{Li} = \sum_{i=1}^{n^-} \varepsilon_{s,i}^- L^- c_{s,i}^{-,*} + \sum_{i=1}^{n^+} \varepsilon_{s,i}^+ L^+ c_{s,i}^{+,*}$$

wherein

"$i$" references an active material of the plurality of active materials,

"$\varepsilon_{s,i}^-$" is a volume fraction of the negative electrode that corresponds to the active material of the plurality of active materials referenced by "$i$,"

"$\varepsilon_{s,i}^+$" is a volume fraction of the positive electrode that corresponds to the active material of the plurality of active materials referenced by "$i$,"

"$L^-$" is a length of the negative electrode,
"$L^+$" is a length of the positive electrode,

"$c_{s,i}^{-,eq}$" is a concentration of lithium ions per unit volume stored by the active material of the plurality of active materials referenced by "$i$" of the negative electrode during an equilibrium condition between the active materials of the plurality of active materials "*", and

"$c_{s,i}^{+,eq}$" is a concentration of lithium ions per unit volume stored by the active material of the plurality of active materials referenced by "$i$" of the positive electrode during the equilibrium condition between the active materials of the plurality of active materials "*".

10. A lithium-ion battery system (100), comprising:

a) at least one lithium-ion battery cell (102) including a positive electrode (124) and a negative electrode (120);
b) a voltage sensor (104) configured to generate a voltage signal representative of a voltage between the positive electrode and the negative electrode during an equilibrium condition of the at least one lithium-ion battery cell;
c) a current sensor (108) configured to generate a current signal representative of a current associated with the lithium-ion battery cell;
d) a memory (112) in which command instructions are stored; and
e) a processor (116) configured to execute the command instructions to use a parameter estimation technique to estimate at least one of a capacity $(C_O^+)$ to store lithium ions of the positive electrode, a capacity $(C_O^-)$ to store lithium ions of the negative electrode, and a total amount of lithium ions ($n_{Li}$) in the lithium-ion battery cell based on a model including the following formulae

$$\frac{d}{dt}SOC^- = \frac{I}{C_0^-},$$

*and*

$$V_{eq}\left(SOC^-\right) = \overline{U}^+\left(\frac{n_{Li}}{C_0^+} - \frac{C_0^-}{C_0^+}SOC^-\right) - \overline{U}^-\left(SOC^-\right),$$

wherein

"$SOC^-$" is a state of charge of the negative electrode,
"$\overline{U}+$" is an average open circuit potential of the positive electrode, and
"$\overline{U}-$" is an average open circuit potential of the negative electrode.

11. The lithium-ion battery system of claim 10, wherein the processor is further configured to estimate a total capacity ($C_0$) of the lithium-ion battery cell according to the following formula

$$C_0 = \min\left(C_0^+, C_0^-, n_{Li}, C_0^+ + C_0^- - n_{Li}\right).$$

12. The lithium-ion battery system of claim 10, wherein the parameter estimation technique is one of nonlinear-least squares, nonlinear Luenberger observer design, and extended Kalman Filter.

13. The lithium-ion battery system of claim 10, wherein the processor is further configured to determine the state of charge of the negative electrode ($SOC^-$) of the lithium-ion battery cell according to a discretized model including the following formulae

$$SOC^-(k+1) = SOC^-(k) + \frac{I}{C_0^-}T_s,$$

$$V_{eq}\left(SOC^-(k)\right) = \overline{U}^+\left(\frac{n_{Li}}{C_0^+} - \frac{C_0^-}{C_0^+}SOC^-(k)\right) - \overline{U}^-\left(SOC^-(k)\right),$$

wherein

$"T_S"$ is a temperature of the lithium-ion battery cell.

**14.** The lithium-ion battery system of claim 13, wherein the processor is further configured to determine the state of charge of the negative electrode ($SOC^-$) according to an optimization problem approach to solve a discretized model including the following formulae

$$\min \quad \left(\left(V_{eq}\left(SOC^-(k)\right) - V_{meas}(k)\right)^2\right),$$

such that,

$$SOC^-(k) = SOC^-(k) + \frac{I}{C_0^-}T_s,$$

and

$$V_{eq}\left(SOC^-(k)\right) = \overline{U}^+\left(\frac{n_{Li}}{C_0^+} - \frac{C_0^-}{C_0^+}SOC^-(k)\right) - \overline{U}^-\left(SOC^-(k)\right),$$

wherein $"V_{meas}"$ is another terminal voltage of the lithium-ion battery cell.

**15.** The lithium-ion battery system of claim 14, wherein:

$SOC^-(0)$, $n_{Li}$, $C_0^+$, and $C_0^-$ are a plurality of states of the discretized model,

the states $n_{Li}$, $C_0^+$, and $C_0^-$ of the plurality of states are constant states of the discretized model, and

the processor is further configured to estimate at least one state of the plurality of states in real-time using an observer design technique including at least one of extended Kalman filter and particle filtering.

**16.** The lithium-ion battery system of claim 15, wherein the optimization problem approach includes at least one of a batch optimization and a recursion-based optimization.

**17.** The lithium-ion battery system of claim 10, wherein:

the positive electrode includes a plurality of active materials,
the negative electrode includes the plurality of active materials,
each active material of the plurality of active materials is configured to store lithium ions, and
the processor uses the parameter estimation technique for each active material of the plurality of active materials.

**18.** The lithium-ion battery system of claim 17, wherein the processor is configured to determine the total amount of lithium ions ($n_{Li}$) of the plurality of active materials based on the following formula

$$n_{Li} = \sum_{i=1}^{n^-}\varepsilon_{s,i}^- L^- c_{s,i}^{-,*} + \sum_{i=1}^{n^+}\varepsilon_{s,i}^+ L^+ c_{s,i}^{+,*}$$

wherein

"*i*" references an active material of the plurality of active materials,

"$\varepsilon_{s,i}^{-}$" is a volume fraction of the negative electrode that corresponds to the active material of the plurality of active materials referenced by "*i*,"

"$\varepsilon_{s,i}^{+}$" is a volume fraction of the positive electrode that corresponds to the active material of the plurality of active materials referenced by "*i*,"

"$L^{-}$" is a length of the negative electrode,

"$L^{+}$" is a length of the positive electrode,

"$c_{s,i}^{-,*}$" is a concentration of lithium ions per unit volume stored by the active material of the plurality of active materials referenced by "*i*" of the negative electrode during an equilibrium condition between the active materials of the plurality of active materials, and

"$c_{s,i}^{+,*}$" is a concentration of lithium ions per unit volume stored by the active material of the plurality of active materials referenced by "*i*" of the positive electrode during an equilibrium condition between the active materials of the plurality of active materials.

**Patentansprüche**

1. Verfahren zum Schätzen von mindestens einem Parameter einer Lithiumionen-Batteriezelle (102), das die folgenden Schritte umfasst:

a) Feststellen einer Klemmenspannung ($V_{eq}$) der Lithiumionen-Batteriezelle während eines Gleichgewichtszustands der Lithiumionen-Batteriezelle mit einem Spannungssensor (104);
b) Feststellen eines Ladestroms (*I*) der Lithiumionen-Batteriezelle während eines Ladevorgangs der Lithiumionen-Batteriezelle mit einem Stromsensor (108); und

c) Verwenden einer Parameterschätztechnik, um eine Kapazität ($C_0^+$), Lithiumionen zu speichern, einer positiven Elektrode (124) der Lithiumionen-Batteriezelle und/oder eine Kapazität ($C_0^-$), Lithiumionen zu speichern, einer negativen Elektrode (120) der Lithiumionen-Batteriezelle und/oder eine Gesamtmenge der Lithiumionen ($n_{Li}$) in der Lithiumionen-Batteriezelle beruhend auf einem Modell zu schätzen, das die folgenden Formeln umfasst:

$$\frac{d}{dt} SOC^- = \frac{I}{C_0^-},$$

$$V_{eq}(SOC^-) = \overline{U}^+ \left( \frac{n_{Li}}{C_0^+} - \frac{C_0^-}{C_0^+} SOC^- \right) - \overline{U}^-(SOC^-),$$

wobei

"$SOC^-$" ein Ladungszustand der negativen Elektrode ist,
"$\overline{U}^+$" ein durchschnittliches Leerlaufpotential der positiven Elektrode während des Gleichgewichtszustands ist, und
"$\overline{U}^-$" ein durchschnittliches Leerlaufpotential der negativen Elektrode während des Gleichgewichtszustands ist; und

d) Erzeugen an Ausgabe, die der Schätzung der Kapazität ($C_0^+$), Lithiumionen zu speichern, der positiven Elektrode und/oder der Kapazität ($C_0^-$), Lithiumionen zu speichern, der negativen Elektrode, und/oder der Gesamtmenge der Lithiumionen ($n_{Li}$) entspricht.

2. Verfahren nach Anspruch 1, das ferner aufweist: Schätzen einer Gesamtkapazität ($C_0$) der Lithiumionen-Batteriezelle entsprechend der folgenden Formel

$$C_0 = \min(C_0^+, C_0^-, n_{Li}, C_0^+ + C_0^- - n_{Li}).$$

**3.** Verfahren nach Anspruch 1, wobei die Parameterschätztechnik eine nicht lineare Methode der kleinsten Fehlerquadrate oder ein nicht lineares Luenberger-Beobachter-Modell oder ein erweitertes Kalman-Filter-Modell ist.

**4.** Verfahren nach Anspruch 1, das ferner aufweist: Feststellen des Ladungszustands der negativen Elektrode (*SOC⁻*) der Lithiumionen-Batteriezelle entsprechend einem diskretisierten Modell, das die folgenden Formeln umfasst:

$$SOC^-(k+1) \quad = SOC^-(k) + \frac{I}{C_0^-} T_s,$$

$$V_{eq}\big(SOC^-(k)\big) \quad = \overline{U}^+\left(\frac{n_{Li}}{C_0^+} - \frac{C_0^-}{C_0^+} SOC^-(k)\right) - \overline{U}^-(SOC^-(k)),$$

wobei
"$T_S$" eine Temperatur der Lithiumionen-Batteriezelle ist.

**5.** Verfahren nach Anspruch 4, das ferner aufweist: Feststellen des Ladungszustands der negativen Elektrode (*SOC⁻*) entsprechend einem Optimierungsproblemansatz, um ein diskretisiertes Modell zu lösen, der die folgenden Formeln umfasst

$$\min \qquad \left(\Big(V_{eq}\big(SOC^-(k)\big) - V_{meas}(k)\Big)^2\right),$$

so dass

$$SOC^-(k+1) \quad = SOC^-(k) + \frac{I}{C_0^-} T_s,$$

und

$$V_{eq}\big(SOC^-(k)\big) \quad = \overline{U}^+\left(\frac{n_{Li}}{C_0^+} - \frac{C_0^-}{C_0^+} SOC^-(k)\right) - \overline{U}^-(SOC^-(k))$$

wobei "$V_{meas}$" eine andere Klemmenspannung der Lithiumionen-Batteriezelle ist.

**6.** Verfahren nach Anspruch 5, wobei:
$SOC^-(0)$, $n_{Li}$, $C_0^+$ und $C_0^-$ eine Vielzahl von Zuständen des diskretisierten Modells sind,
die Zustände $n_{Li}$, $C_0^+$ und $C_0^-$ der Vielzahl der Zustände konstante Zustände des diskretisierten Modells sind, und
das Verfahren ferner das Schätzen mindestens eines Zustands der Vielzahl der Zustände in Echtzeit unter Verwendung einer Beobachter-Modelltechnik aufweist, die das erweiterte Kalman-Filter-Modell und/oder eine Partikelfilterung umfasst.

**7.** Verfahren nach Anspruch 6, wobei der Optimierungsproblemansatz eine Batch-Optimierung und/oder eine rekursionsbasierte Optimierung umfasst.

**8.** Verfahren nach Anspruch 1, wobei:

die positive Elektrode eine Vielzahl von aktiven Materialien enthält,
die negative Elektrode die Vielzahl der aktiven Materialien enthält,
jedes aktive Material der Vielzahl der aktiven Materialien konfiguriert ist, Lithiumionen zu speichern, und

das Verwenden der Parameterschätztechnik das Verwenden der Parameterschätztechnik für jedes aktive Material der Vielzahl der aktiven Materialien umfasst.

9. Verfahren nach Anspruch 8, wobei die Gesamtmenge der Lithiumionen ($n_{Li}$) beruhend auf der folgenden Formel bestimmt wird

$$n_{Li} = \sum_{i=1}^{n^-} \varepsilon_{s,i}^- L^- c_{s,i}^{-,*} + \sum_{i=1}^{n^+} \varepsilon_{s,i}^+ L^+ c_{s,i}^{+,*}$$

wobei

"i" sich auf ein aktives Material der Vielzahl der aktiven Materialien bezieht,

„$\varepsilon_{s,i}^-$" ein Volumenbruchteil der negativen Elektrode ist, der dem aktiven Material der Vielzahl der aktiven Materialien entspricht, das durch "i" referenziert wird,

„$\varepsilon_{s,i}^+$" ein Volumenbruchteil der positiven Elektrode ist, der dem aktiven Material der Vielzahl der aktiven Materialien entspricht, das durch "i" referenziert wird,

"$L^-$" eine Länge der negativen Elektrode ist,

"$L^+$" eine Länge der positiven Elektrode ist, „$c_{s,i}^{-,eq}$" eine Konzentration der Lithiumionen pro Volumeneinheit ist, die durch das aktive Material der Vielzahl der aktiven Materialien, das durch "i" referenziert wird, der negativen Elektrode während eines Gleichgewichtszustands zwischen den aktiven Materialien der Vielzahl der aktiven Materialien "*" gespeichert werden, und

„$c_{s,i}^{+,eq}$" eine Konzentration der Lithiumionen pro Volumeneinheit ist, die durch das aktive Material der Vielzahl der aktiven Materialien, das durch "i" referenziert wird, der positiven Elektrode während des Gleichgewichtszustands zwischen den aktiven Materialien der Vielzahl der aktiven Materialien "*" gespeichert werden.

10. Lithiumionen-Batteriesystem (100), das Folgendes umfasst:

a) mindestens eine Lithiumionen-Batteriezelle (102), die eine positive Elektrode (124) und eine negative Elektrode (120) umfasst;

b) einen Spannungssensor (104), der konfiguriert ist, ein Spannungssignal zu erzeugen, das für eine Spannung zwischen der positiven Elektrode und der negativen Elektrode während eines Gleichgewichtszustands der mindestens einen Lithiumionen-Batteriezelle repräsentativ ist;

c) einen Stromsensor (108), der konfiguriert ist, ein Stromsignal zu erzeugen, das für einen Strom repräsentativ ist, der mit der Lithiumionen-Batteriezelle verbunden ist;

d) einen Speicher (112), in dem Befehlsanweisungen gespeichert sind; und

e) einen Prozessor (116), der konfiguriert ist, die Befehlsanweisungen auszuführen, um eine Parameterschätztechnik zu verwenden, um eine Kapazität ($C_0^+$), Lithiumionen zu speichern, der positiven Elektrode und/oder eine Kapazität ($C_0^-$), Lithiumionen zu speichern, der negativen Elektrode und/oder eine Gesamtmenge der Lithiumionen ($n_{Li}$) in der Lithiumionen-Batteriezelle beruhend auf einem Modell zu schätzen, das die folgenden Formeln umfasst

$$\frac{d}{dt}SOC^- = \frac{I}{C_0^-},$$

und

$$V_{eq}(SOC^-) = \bar{U}^+\left(\frac{n_{Li}}{C_0^+} - \frac{C_0^-}{C_0^+}SOC^-\right) - \bar{U}^-(SOC^-),$$

wobei

"*SOC⁻*" ein Ladungszustand der negativen Elektrode ist,
"$\overline{U}^+$" ein durchschnittliches Leerlaufpotential der positiven Elektrode ist, und
"$\overline{U}^-$" ein durchschnittliches Leerlaufpotential der negativen Elektrode ist.

**11.** Lithiumionen-Batteriesystem nach Anspruch 10, wobei der Prozessor ferner konfiguriert ist, eine Gesamtkapazität ($C_0$) der Lithiumionen-Batteriezelle entsprechend der folgenden Formel zu schätzen:

$$C_0 = \min(C_0^+, C_0^-, n_{Li}, C_0^+ + C_0^- - n_{Li}).$$

**12.** Lithiumionen-Batteriesystem nach Anspruch 10, wobei die Parameterschätztechnik eine nicht lineare Methode der kleinsten Fehlerquadrate oder ein nicht lineares Luenberger-Beobachter-Modell oder ein erweitertes Kalman-Filter-Modell ist.

**13.** Lithiumionen-Batteriesystem nach Anspruch 10, wobei der Prozessor ferner konfiguriert ist, den Ladungszustand der negativen Elektrode (*SOC⁻*) der Lithiumionen-Batteriezelle entsprechend einem diskretisierten Modell zu bestimmen, das die folgenden Formeln umfasst:

$$SOC^-(k+1) \quad = SOC^-(k) + \frac{I}{C_0^-} T_s,$$

$$V_{eq}\big(SOC^-(k)\big) \quad = \overline{U}^+ \left( \frac{n_{Li}}{C_0^+} - \frac{C_0^-}{C_0^+} SOC^-(k) \right) - \overline{U}^-(SOC^-(k)),$$

wobei
"$T_S$" eine Temperatur der Lithiumionen-Batteriezelle ist.

**14.** Lithiumionen-Batteriesystem nach Anspruch 13, wobei der Prozessor ferner konfiguriert ist, den Ladungszustand der negativen Elektrode (*SOC⁻*) entsprechend einem Optimierungsproblemansatz zu bestimmen, um ein diskretisiertes Modell zu lösen, das die folgenden Formeln umfasst:

$$\min \quad \left( \big( V_{eq}\big(SOC^-(k)\big) - V_{meas}(k) \big)^2 \right),$$

so dass

$$SOC^-(k) \quad = SOC^-(k) + \frac{I}{C_0^-} T_s,$$

und

$$V_{eq}\big(SOC^-(k)\big) \quad = \overline{U}^+ \left( \frac{n_{Li}}{C_0^+} - \frac{C_0^-}{C_0^+} SOC^-(k) \right) - \overline{U}^-(SOC^-(k))$$

wobei "$V_{meas}$" eine andere Klemmenspannung der Lithiumionen-Batteriezelle ist.

**15.** Lithiumionen-Batteriesystem nach Anspruch 14, wobei:
$SOC^-(0)$, $n_{Li}$, $C_0^+$ und $C_0^-$ eine Vielzahl von Zuständen des diskretisierten Modells sind,
die Zustände $n_{Li}$, $C_0^+$ und $C_0^-$ der Vielzahl der Zustände konstante Zustände des diskretisierten Modells sind, und
der Prozessor ferner konfiguriert ist, mindestens einen Zustand der Vielzahl der Zustände in Echtzeit unter Verwendung einer Beobachter-Modelltechnik zu schätzen, die das erweiterte Kalman-Filter-Modell und/oder eine Partikelfilterung umfasst.

16. Lithiumionen-Batteriesystem nach Anspruch 15, wobei der Optimierungsproblemansatz eine Batch-Optimierung und/oder eine rekursionsbasierte Optimierung umfasst.

17. Lithiumionen-Batteriesystem nach Anspruch 10, wobei:

die positive Elektrode eine Vielzahl von aktiven Materialien enthält,
die negative Elektrode die Vielzahl der aktiven Materialien enthält,
jedes aktive Material der Vielzahl der aktiven Materialien konfiguriert ist, Lithiumionen zu speichern, und
der Prozessor die Parameterschätztechnik für jedes aktive Material der Vielzahl der aktiven Materialien verwendet.

18. Lithiumionen-Batteriesystem nach Anspruch 17, wobei der Prozessor konfiguriert ist, die Gesamtmenge der Lithiumionen ($n_{Li}$) der Vielzahl der aktiven Materialien beruhend auf der folgenden Formel zu bestimmen:

$$n_{Li} = \sum_{i=1}^{n^-} \varepsilon_{s,i}^- L^- c_{s,i}^{-,*} + \sum_{i=1}^{n^+} \varepsilon_{s,i}^+ L^+ c_{s,i}^{+,*}$$

wobei

"i" sich auf ein aktives Material der Vielzahl der aktiven Materialien bezieht,

„$\varepsilon_{s,i}^-$" ein Volumenbruchteil der negativen Elektrode ist, der dem aktiven Material der Vielzahl der aktiven Materialien entspricht, das durch "i" referenziert wird,

„$\varepsilon_{s,i}^+$" ein Volumenbruchteil der positiven Elektrode ist, der dem aktiven Material der Vielzahl der aktiven Materialien entspricht, das durch "i" referenziert wird,

"$L^-$" eine Länge der negativen Elektrode ist,
"$L^+$" eine Länge der positiven Elektrode ist,

„$c_{s,i}^{-,*}$" eine Konzentration der Lithiumionen pro Volumeneinheit ist, die durch das aktive Material der Vielzahl der aktiven Materialien, das durch "i" referenziert wird, der negativen Elektrode während eines Gleichgewichtszustands zwischen den aktiven Materialien der Vielzahl der aktiven Materialien gespeichert werden, und

„$c_{s,i}^{+,*}$" eine Konzentration der Lithiumionen pro Volumeneinheit ist, die durch das aktive Material der Vielzahl der aktiven Materialien, das durch "i" referenziert wird, der positiven Elektrode während eines Gleichgewichtszustands zwischen den aktiven Materialien der Vielzahl der aktiven Materialien gespeichert werden.

## Revendications

1. Procédé d'estimation d'au moins un paramètre d'une cellule de batterie au lithium-ion (102), comprenant les étapes suivantes :

a) déterminer une tension aux bornes ($V_{éq}$) de la cellule de batterie au lithium-ion dans un état d'équilibre de la cellule de batterie au lithium-ion avec un capteur de tension (104) ;
b) déterminer un courant de charge ($I$) de la cellule de batterie au lithium-ion pendant une opération de charge de la cellule de batterie au lithium-ion avec un capteur de courant (108) ; et
c) utiliser une technique d'estimation de paramètres pour estimer au moins un paramètre parmi une capacité ($C_0^+$) à stocker des ions lithium d'une électrode positive (124) de la cellule de batterie au lithium-ion, une capacité ($C_0^-$) à stocker des ions lithium d'une électrode négative (120) de la cellule de batterie au lithium-ion et une quantité totale d'ions lithium ($n_{Li}$) dans la cellule de batterie au lithium-ion sur la base d'un modèle comportant les formules suivantes :

$$\frac{d}{dt}SOC^- = \frac{I}{C_0^-},$$

$$V_{\acute{e}q}(SOC^-) = \overline{U}^+\left(\frac{n_{Li}}{C_0^+} - \frac{C_0^-}{C_0^+}SOC^-\right) - \overline{U}^-(SOC^-),$$

dans lesquelles

« $SOC^-$ » est un état de charge de l'électrode négative,
« $\overline{U}^+$ » est un potentiel en circuit ouvert moyen de l'électrode positive dans l'état d'équilibre, et
« $\overline{U}^-$ » est un potentiel en circuit ouvert moyen de l'électrode négative dans l'état d'équilibre ; et

d) générer une sortie correspondant à l'estimation d'au moins un paramètre parmi la capacité ($C_0^+$) à stocker des ions lithium de l'électrode positive, la capacité ($C_0^-$) à stocker des ions lithium de l'électrode négative et la quantité totale d'ions lithium ($n_{Li}$).

**2.** Procédé de la revendication 1, comprenant en outre l'étape suivante :

estimer une capacité totale ($C_0$) de la cellule de batterie au lithium-ion selon la formule suivante :

$$C_0 = \min(C_0^+, C_0^-, n_{Li}, C_0^+ + C_0^- - n_{Li}).$$

**3.** Procédé de la revendication 1, dans lequel la technique d'estimation de paramètres est une technique parmi les moindres carrés non linéaires, la conception d'observateurs de Luenberger pour systèmes non linéaires, et le filtre de Kalman étendu.

**4.** Procédé de la revendication 1, comprenant en outre l'étape suivante :

déterminer l'état de charge de l'électrode négative ($SOC^-$) de la cellule de batterie au lithium-ion selon un modèle discrétisé comportant les formules suivantes :

$$SOC^-(k+1) = SOC^-(k) + \frac{I}{C_0^-}T_s,$$

$$V_{\acute{e}q}(SOC^-(k)) = \overline{U}^+\left(\frac{n_{Li}}{C_0^+} - \frac{C_0^-}{C_0^+}SOC^-(k)\right) - \overline{U}^-(SOC^-(k)),$$

dans lesquelles
« $T_S$ » est une température de la cellule de batterie au lithium-ion.

**5.** Procédé de la revendication 1, comprenant en outre l'étape suivante :

déterminer l'état de charge de l'électrode négative ($SOC^-$) selon une approche de problème d'optimisation pour résoudre un modèle discrétisé comportant les formules suivantes :

$$min\big((V_{\acute{e}q}(SOC^-(k)) - V_{meas}(k))^2\big),$$

de telle sorte que

$$SOC^-(k) = SOC^-(k) + \frac{I}{C_0^-} T_s ,$$

et

$$V_{\acute{e}q}(SOC^-(k)) = \overline{U}^+\left(\frac{n_{Li}}{c_0^+} - \frac{c_0^-}{c_0^+} SOC^-(k)\right) - \overline{U}^-(SOC^-(k)),$$

dans lesquelles « $V_{meas}$ » est une autre tension aux bornes de la cellule de batterie au lithium-ion.

6. Procédé de la revendication 5, dans lequel :

$SOC^-(0)$, $n_{Li}$, $C_0^+$ et $C_0^-$ sont une pluralité d'états du modèle discrétisé,

les états $n_{Li}$, $C_0^+$ et $C_0^-$ de la pluralité d'états sont des états constants du modèle discrétisé, et

le modèle comprend en outre l'estimation d'au moins un état de la pluralité d'états en temps réel en utilisant une technique de conception d'observateurs comportant un filtre de Kalman étendu et/ou un filtrage particulaire.

7. Procédé de la revendication 6, dans lequel l'approche de problème d'optimisation comporte une optimisation par lots et/ou une optimisation à base de récursivité.

8. Procédé de la revendication 1, dans lequel :

l'électrode positive comporte une pluralité de matériaux actifs,

l'électrode négative comporte la pluralité de matériaux actifs,

chaque matériau actif de la pluralité de matériaux actifs est configuré pour stocker des ions lithium, et

l'utilisation de la technique d'estimation de paramètres comporte l'utilisation de la technique d'estimation de paramètres pour chaque matériau actif de la pluralité de matériaux actifs.

9. Procédé de la revendication 8, dans lequel la quantité totale d'ions lithium ($n_{Li}$) est déterminée sur la base de la formule suivante :

$$n_{Li} = \sum_{i=1}^{n^-} \varepsilon_{s,i}^- L^- c_{s,i}^{-,*} + \sum_{i=1}^{n^+} \varepsilon_{s,i}^+ L^+ c_{s,i}^{+,*}$$

dans laquelle

« $i$ » fait référence à un matériau actif de la pluralité de matériaux actifs,

« $\varepsilon_{s,i}^-$ » est une fraction volumique de l'électrode négative qui correspond au matériau actif de la pluralité de matériaux actifs référencé par « $i$ »,

« $\varepsilon_{s,i}^+$ » est une fraction volumique de l'électrode positive qui correspond au matériau actif de la pluralité de matériaux actifs référencé par « $i$ »,

« $L^-$ » est une longueur de l'électrode négative,

« $L^+$ » est une longueur de l'électrode positive, «

$c_{s,i}^{-,\acute{e}q}$ » est une concentration d'ions lithium par volume unitaire stockés par le matériau actif de la pluralité de matériaux actifs référencé par « $i$ » de l'électrode négative dans un état d'équilibre entre les matériaux actifs de la pluralité de matériaux actifs « * », et

« $c_{s,i}^{+,\acute{e}q}$ » est une concentration d'ions lithium par volume unitaire stockés par le matériau actif de la pluralité de matériaux actifs référencé par « $i$ » de l'électrode positive dans l'état d'équilibre entre les matériaux actifs de la pluralité de matériaux actifs « * ».

10. Système de batterie au lithium-ion (100), comprenant :

a) au moins une cellule de batterie au lithium-ion (102) comportant une électrode positive (124) et une électrode négative (120) ;

b) un capteur de tension (104) configuré pour générer un signal de tension représentatif d'une tension entre l'électrode positive et l'électrode négative dans un état d'équilibre de l'au moins une cellule de batterie au lithium-ion ;

c) un capteur de courant (108) configuré pour générer un signal de courant représentatif d'un courant associé à la cellule de batterie au lithium-ion ;

d) une mémoire (112) dans laquelle sont stockées des instructions de commande ; et

e) un processeur (116) configuré pour exécuter les instructions de commande pour utiliser une technique d'estimation de paramètres pour estimer au moins un paramètre parmi une capacité ($C_0^+$) à stocker des ions lithium de l'électrode positive, une capacité ($C_0^-$) à stocker des ions lithium de l'électrode négative et une quantité totale d'ions lithium ($n_{Li}$) dans la cellule de batterie au lithium-ion sur la base d'un modèle comportant les formules suivantes :

$$\frac{d}{dt}SOC^- = \frac{I}{C_0^-},$$

et

$$V_{éq}(SOC^-) = \overline{U}^+\left(\frac{n_{Li}}{C_0^+} - \frac{C_0^-}{C_0^+}SOC^-\right) - \overline{U}^-(SOC^-),$$

dans lesquelles

« $SOC^-$ » est un état de charge de l'électrode négative,
« $\overline{U}^+$ » est un potentiel en circuit ouvert moyen de l'électrode positive, et
« $\overline{U}^-$ » est un potentiel en circuit ouvert moyen de l'électrode négative.

11. Système de batterie au lithium-ion de la revendication 10, dans lequel le processeur est en outre configuré pour estimer une capacité totale ($C_0$) de la cellule de batterie au lithium-ion selon la formule suivante :

$$C_0 = \min(C_0^+, C_0^-, n_{Li}, C_0^+ + C_0^- - n_{Li}).$$

12. Système de batterie au lithium-ion de la revendication 10, dans lequel la technique d'estimation de paramètres est une technique parmi les moindres carrés non linéaires, la conception d'observateurs de Luenberger pour systèmes non linéaires, et le filtre de Kalman étendu.

13. Système de batterie au lithium-ion de la revendication 10, dans lequel le processeur est en outre configuré pour déterminer l'état de charge de l'électrode négative ($SOC^-$) de la cellule de batterie au lithium-ion selon un modèle discrétisé comportant les formules suivantes :

$$SOC^-(k+1) = SOC^-(k) + \frac{I}{C_0^-}T_s,$$

$$V_{éq}(SOC^-(k)) = \overline{U}^+\left(\frac{n_{Li}}{C_0^+} - \frac{C_0^-}{C_0^+}SOC^-(k)\right) - \overline{U}^-(SOC^-(k)),$$

dans lesquelles
« $T_S$ » est une température de la cellule de batterie au lithium-ion.

14. Système de batterie au lithium-ion de la revendication 13, dans lequel le processeur est en outre configuré pour déterminer l'état de charge de l'électrode négative ($SOC^-$) selon une approche de problème d'optimisation pour résoudre un modèle discrétisé comportant les formules suivantes :

$$min\left((V_{éq}(SOC^-(k)) - V_{meas}(k))^2\right),$$

de telle sorte que

$$SOC^-(k) = SOC^-(k) + \frac{I}{C_0^-}T_s,$$

et

$$V_{éq}(SOC^-(k)) = \overline{U}^+\left(\frac{n_{Li}}{c_0^+} - \frac{c_0^-}{c_0^+}SOC^-(k)\right) - \overline{U}^-(SOC^-(k)),$$

dans lesquelles « $V_{meas}$ » est une autre tension aux bornes de la cellule de batterie au lithium-ion.

**15.** Système de batterie au lithium-ion de la revendication 14, dans lequel :

$SOC^-$(0), $n_{Li}$, $C_0^+$ et $C_0^-$ sont une pluralité d'états du modèle discrétisé,

les états $n_{Li}$, $C_0^+$ et $C_0^-$ de la pluralité d'états sont des états constants du modèle discrétisé, et

le processeur est en outre configuré pour estimer au moins un état de la pluralité d'états en temps réel en utilisant une technique de conception d'observateurs comportant un filtre de Kalman étendu et/ou un filtrage particulaire.

**16.** Système de batterie au lithium-ion de la revendication 15, dans lequel l'approche de problème d'optimisation comporte une optimisation par lots et/ou une optimisation à base de récursivité.

**17.** Système de batterie au lithium-ion de la revendication 10, dans lequel :

l'électrode positive comporte une pluralité de matériaux actifs,
l'électrode négative comporte la pluralité de matériaux actifs,
chaque matériau actif de la pluralité de matériaux actifs est configuré pour stocker des ions lithium, et
le processeur utilise la technique d'estimation de paramètres pour chaque matériau actif de la pluralité de matériaux actifs.

**18.** Système de batterie au lithium-ion de la revendication 17, dans lequel le processeur est configuré pour déterminer la quantité totale d'ions lithium ($n_{Li}$) de la pluralité de matériaux actifs sur la base de la formule suivante :

$$n_{Li} = \sum_{i=1}^{n^-} \varepsilon_{s,i}^- L^- c_{s,i}^{-,*} + \sum_{i=1}^{n^+} \varepsilon_{s,i}^+ L^+ c_{s,i}^{+,*}$$

dans laquelle

« $i$ » fait référence à un matériau actif de la pluralité de matériaux actifs,

« $\varepsilon_{s,i}^-$ » est une fraction volumique de l'électrode négative qui correspond au matériau actif de la pluralité de matériaux actifs référencé par « $i$ »,

« $\varepsilon_{s,i}^+$ » est une fraction volumique de l'électrode positive qui correspond au matériau actif de la pluralité de matériaux actifs référencé par « $i$ »,

« $L^-$ » est une longueur de l'électrode négative,
« $L^+$ » est une longueur de l'électrode positive,

« $c_{s,i}^{-,*}$ » est une concentration d'ions lithium par volume unitaire stockés par le matériau actif de la pluralité de matériaux actifs référencé par « $i$ » de l'électrode négative dans un état d'équilibre entre les matériaux actifs de la pluralité de matériaux actifs, et

« $c_{s,i}^{+,*}$ » est une concentration d'ions lithium par volume unitaire stockés par le matériau actif de la pluralité de matériaux actifs référencé par « $i$ » de l'électrode positive dans un état d'équilibre entre les matériaux actifs de la pluralité de matériaux actifs.

FIG. 1

FIG. 2

Negative Electrode

Positive Electrode

124

120

$C_0^-$     $n_{Li}$     $C_0^+$

FIG. 3

404

DETERMINE TERMINAL VOLTAGE
DURING EQUILIBRIUM CONDITION

400

408

DETERMINE CURRENT
DURING CHARGING OPERATION

412

ESTIMATE BATTERY PARAMETER

416

OUTPUT ESTIMATED PARAMETER

# FIG. 4

**REFERENCES CITED IN THE DESCRIPTION**

**Patent documents cited in the description**

- US 61767502 A
- WO 2013173610 A1
- EP 1562048 A1
- US 2012105068 A1
- US 7726975 B